Europäisches Patentamt

European Patent Office

Office européen des brevets

(11) Veröffentlichungsnummer: **0 260 545 B1**

(12) **EUROPÄISCHE PATENTSCHRIFT**

(45) Veröffentlichungstag der Patentschrift: **24.03.93**

(21) Anmeldenummer: **87112935.9**

(22) Anmeldetag: **04.09.87**

(51) Int. Cl.⁵: **H03H 19/00**

(54) **Aktives Filter.**

(30) Priorität: **19.09.86 DE 3631827**

(43) Veröffentlichungstag der Anmeldung:
**23.03.88 Patentblatt 88/12**

(45) Bekanntmachung des Hinweises auf die
Patenterteilung:
**24.03.93 Patentblatt 93/12**

(84) Benannte Vertragsstaaten:
**AT DE FR GB IT SE**

(56) Entgegenhaltungen:

**INTERNATIONAL JOURNAL OF ELECTRO-
NICS, Band 56, Nr. 6, Juni 1984, Seiten
763-770, Basingstoke, Hampshire, GB; S.M.
BOZIC et al.: "Analogue sample band-pass
filter design with the SCADL"**

**IEEE TRANSACTIONS ON CONSUMER ELEC-
TRONICS, Band CE-33, Nr. 3, August 1982,
Seiten 383-393; R. OGAWA et al.:
"Development of radio data system decoder
IC's"**

(73) Patentinhaber: **Blaupunkt-Werke GmbH
Robert-Bosch-Strasse 200
W-3200 Hildesheim(DE)**

(72) Erfinder: **Hegeler, Wilhelm
Grosse Venedig 23
W-3200 Hildesheim(DE)**

(74) Vertreter: **Eilers, Norbert, Dipl.-Phys.
Blaupunkt-Werke GmbH Robert-
Bosch-Strasse 200
W-3200 Hildesheim (DE)**

**Beschreibung**

Die Erfindung betrifft ein aktives Filter mit geschalteten Kapazitäten für das VRF-Signal eines UKW-Empfängers, der im Oberbegriff des Anspruchs 1 angegebenen Art.

In UKW-Empfängern wird durch FM-Demodulation des Empfangssignals das sog. MPX-Signal wiedergewonnen. Dieses MPX-Signal ist ein Frequenzgemisch und besitzt neben dem NF-Signal und dem Stereosignal zwei additive Teile, einmal ein amplitudenmoduliertes VRF-Signal (Verkehrs-Rundfunk-Signal) mit einem 57 kHz-Träger und zum anderen ein amplitudenmoduliertes RDS-Signal mit unterdrücktem Träger gleicher Frequenz, der gegenüber dem VRF-Träger jedoch um 90° phasenverschoben ist. Dabei enthält die sehr niederfrequente Amplitudenmodulation (20 - 200 Hz) des hochfrequenten VRF-Trägers besondere Schaltinformationen, wie Bereichs- und Durchsagekennung oder Verkehrfunk-Kennfrequenzen. Die RDS-Informationen im RDS-Signal betreffen Senderidentifikation, Programmtyp, alternative Sendefrequenzen etc. Zur Übertragung dieser RDS-Information wird senderseitig eine 1,1875 kHz-Rechteckschwingung mit einer die RDS-Information kennzeichnenden Bitfolge phasenmoduliert. Nach Tiefpaßfilterung wird diese phasenmodulierte Schwingung auf einen 57 kHz-Träger aufmoduliert (Amplitudenmodulation), der gegenüber dem VRF-Träger um 90° phasenverschoben ist. Im modulierten Signal wird dann der Träger unterdrückt und das entstehende RDS-Signal dem MPX-Signal hinzugefügt. Je nach Sender kann der eine der beiden additiven Teile des MPX-Signals fehlen.

Zur Siebung eines solchen VRF-Signals werden in UKW-Empfängern aktive Analogfilter eingesetzt, mitunter als sog. Switched Capacitor- (SC-) Filter der eingangs genannten Art. In solchen SC-Filtern sind die bei einem aktiven Filter üblicherweise verwendeten Widerstände der RC-Glieder durch geschaltete Kondensatoren ersetzt. Bei den heute verwendeten SC-MOS-Technologien liegen die relativen Fehler der Kapazitäten eines Kondensatorpaars bei weniger als 1%, unter der Voraussetzung, daß die Flächenabmessungen des bei gleicher Schichtdicke kleineren Kondensators ein Mindestmaß nicht unterschreitet.

Bei bekannten Filtern der eingangs genannten Art wählt man zur Erzielung eines nahezu sinusförmigen Signals ohne viel Klirren und Quantisierungsrauschen am Filterausgang eine Schaltfrequenz zum Schalten der Kondensatoren, die sehr groß gegenüber der Signalfrequenz am Filtereingang ist, da sich dann die geschalteten Kapazitäten fast wie Widerstände verhalten. Dies bedingt extreme Kapazitätsverhältnisse und führt zu großen flächenaufwendigen Lösungen bei der Kapazitätsrealisierung, was wiederum bei der Integration Probleme hinsichtlich des Bauvolumens schafft.

Ein anders aufgebautes aktives Analogfilter, das ein analoges Schieberegisten verwendet und gut integrierbar ist, ist das sogenannte "Analogue Sample Filter", das aus INTERNATIONAL JOURNAL OF ELECTRONICS, Band 56, Nr. 6, Juni 1984, Seiten 763-770, Basingstoke, Hampshire, GB; S.M. BOZIC et al.: "Analogue sample band-pass filter design with the SCADL" bekannt ist. In diesem Filter verhalten sich die Kapazitäten nicht als Widerstände, sondern als Spannungspeicherzellen für das "Sample and Hold" und das Register.

Der Erfindung liegt die Aufgabe zugrunde, für das MPX-Signal eines UKW-Empfängers ein spezielles Filter zu schaffen, in welchem die in SC-MOS-Technologie erstellten Kondensatoren nur geringe Flächenabmessungen aufweisen.

Die Aufgabe ist bei einem aktiven Filter der im Oberbegriff des Anspruchs 1 definierten Gattung erfindungsgemäß durch die Merkmale im Kennzeichnungsteil des Anspruchs 1 gelöst.

Das erfindungsgemäße Filter hat den Vorteil, daß durch die niedrige Schaltfrequenz, die in einem bevorzugten Ausführungsbeispiel das Vierfache des Eingangssignals des Filters beträgt, und durch die Verwendung eines analogen Schieberegisters anstelle der sonst üblichen Integratoren die kritischen Kapazitätsverhältnisse in der Größenordnung von 1:1 liegen, so daß bei hoher Genauigkeit der Kondensatoren ein nur geringer Flächenbedarf erforderlich ist. Die Resonanzfrequenz des Filters ist nahezu ausschließlich von der Schaltfrequenz abhängig und nahezu unbeeinflußt von den Toleranzen der Bauteile. Bei Verwendung eines Schieberegisters mit zwei Registerstufen und einer entsprechenden Schaltfrequenz von dem Vierfachen der der gewünschten Bandmittenfrequenz steht am Ausgang des aktiven Filters zweiter Ordnung eine Treppenkurve mit vier Werten pro Signalperiode an, was für eine Unterabtastung oder für die Weiterverarbeitung der 4 Quadranten-Information ausreichend ist. Ist die Schaltfrequenz auf das Vierfache der Frequenz des 57 kHz-VRF-Signals eingerastet, z.B. mittels einer Phase-Locked-Loop (PLL) gemäß Anspruch 13, so kann aus der Ausgangsspannung des Filters sehr genau die VRF-Kennung gewonnen werden.

Vorteilhafte Ausführungsformen der Erfindung mit zweckmäßigen Weiterbildungen und Ausgestaltungen ergeben sich aus den Ansprüchen 2 - 13.

Eine vorteilhafte Ausführungsform der Erfindung zeigt dabei besonders Anspruch 3. Durch die schwache Rückkopplung erster Ordnung läßt sich die Resonanzfrequenz des Filters in leicht kontrollierbarer

2

Weise verschieben.

Eine vorteilhafte Ausführungsform der Erfindung ergibt sich auch aus Anspruch 4. Durch die Hintereinanderschaltung zweier bis auf den invertierenden dritten Verstärker identischer Schaltungsanordnungen läßt sich ein Bandfilter aufbauen, dessen Mittenfrequenz von der Schaltfrequenz bestimmt ist und dessen Bandbreite durch die Wahl der Verstärkung des dritten Verstärkers der ersten Schaltungsanordnung und des dritten invertierenden Verstärkers der zweiten Schaltungsanordnung eingestellt werden kann. Bei Verwendung eines Schieberegisters mit zwei Register- bzw. Verzögerungsstufen und einer entsprechenden Schaltfrequenz von dem Vierfachen der Frequenz des Eingangssignals ergibt sich ein Bandfilter vierter Ordnung, dessen Bandbreite und Welligkeit proportional des Betrages der in beiden dritten Verstärkern gleich, aber mit umgekehrten Vorzeichen eingestellten Verstärkung ist. Durch Nachschalten einer weiteren identischen Schaltungsanordnung, bei welcher jedoch die Verstärkung des dritten Verstärkers Null ist, läßt sich die Welligkeit und Selektion noch wesentlich verbessern.

Bei einem solchen Bandfilter, dessen Schaltfrequenz mittels einer PLL zudem noch auf das Vierfache der 57 kHz-Frequenz des VRF-Signals eingerastet ist, können die vier Werte pro Signalperiode des Ausgangssignals als Wertpaare der Sinus- und Kosinuskomponente des VRF-Signals gedeutet werden. Da - wie eingangs ausführlich dargelegt - der unterdrückte Träger des RDS-Signals um 90° gegenüber dem gleichfrequenten 57 kHz-Träger des VRF-Signals phasenverschoben ist, können aus den beiden Komponenten durch Demodulation die VRF- und die RDS-Informationen zurückgewonnen werden.

Vorteilhafte Ausführungsformen der Erfindung ergeben sich auch aus den Ansprüchen 5 und 6. In beiden Techniken sind hohe Genauigkeiten möglich, ohne daß die Toleranzen der Kapazitäten eine Rolle spielt. Bei der Sample- and Hold-Technologie wird eine Register- bzw. Verzögerungsstufe des analogen Schieberegisters zwecks Zwischenspeicherung der Abtastwerte durch zwei hintereinandergeschaltete Sample- and Hold-Glieder realisiert, da der Tatsache Rechnung getragen werden muß, daß bei Einspeicherung eines neuen Wertes der bis dahin am Ausgang des Haltegliedes befindliche Wert verlorengeht. Zur Reduktion des Haltegliedbedarfs kann eine zeitlich gestaffelte Umspeicherung durchgeführt werden. In diesem Falle besteht nur noch die erste Registerstufe aus zwei Sample- and Hold-Gliedern, während alle übrigen Registerstufen nur noch ein einziges Haltglied aufweisen.

Eine vorteilhafte Ausführungsform der Erfindung ergibt sich auch aus Anspruch 7. Durch die hier angegebenen Maßnahmen läßt sich das erfindungsgemäße aktive Filter in vorteilhafter Weise technisch realisieren.

Eine vorteilhafte Ausführungsform der Erfindung ergibt sich auch aus Anspruch 11. Bei dieser Ausbildung des Schieberegisters findet die ansonsten mindestens in der ersten Registerstufe des Schieberegisters erforderliche Zwischenspeicherung der laufend weitergeschobenen beiden analogen Informationen in dem invertierenden Summierverstärker statt.

Die Erfindung ist anhand von in der Zeichnung dargestellten Ausführungsbeispielen im folgenden näher beschrieben. Es zeigen:

Fig. 1     ein Prinzipschaltbild eines aktiven Filters zweiter Ordnung,
Fig. 2     ein Prinzipschaltbild eines aktiven Bandfilters vierter Ordnung mit einstellbarer Bandbreite,
Fig. 3     ein Schaltbild eines schaltungstechnischen Ausführungsbeispiels des Bandfilters in Fig. 2,
Fig. 4     ein Zeitdiagramm der von einem Taktimpulsgenerator in der Schaltungsanordnung in Fig. 3 ausgegebenen Schaltimpulsfolgen.

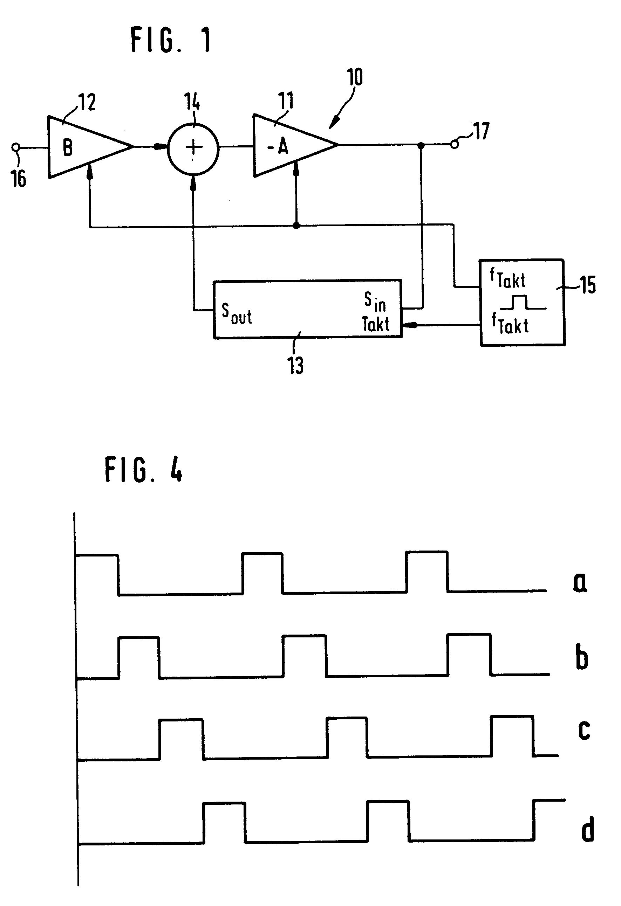

In Fig. 1 ist das Schaltungsprinzip des aktiven Filters für ein VRF-Signal eines UKW-Empfängers dargestellt. Das aktive Filter weist eine Schaltungsanordnung 10, bestehend aus einem invertierenden ersten Verstärker 11 mit der Verstärkung A, einem zweiten Verstärker 12 mit der Verstärkung B, einem analogen Schieberegister 13 mit mindestens zwei Verzögerungs- bzw. Registerstufen und einem Summierer 14, und einen Rechteckimpulsgenerator 15 auf, der Schaltimpulsfolgen mit Schaltfrequenz für die die Verstärkung A und B einstellenden geschalteten Kapazitäten und das Schieberegister 13 erzeugt. Die Frequenz der Schaltimpulsfolgen ist gleich dem mit der Anzahl der Registerstufen des Schieberegisters 13 multiplizierten Zweifachen der gewünschten Bandmittenfrequenz bzw. Resonanzfrequenz, die gleich der Frequenz des am Eingang 16 der Schaltungsanordnung, der zugleich der Filtereingang ist, anliegenden 57 kHz-Trägers ist. Der zweite Verstärker 12 ist dabei eingangsseitig unmittelbar an dem Eingang 16 der Schaltungsanordnung 10 angeschlossen, während der invertierende erste Verstärker 11 ausgangsseitig einerseits mit dem den Filterausgang bildenden Ausgang 17 der Schaltungsanordnung und andererseits mit dem Speichereingang des Schieberegisters 13 verbunden ist. Der Summierer 14 ist eingangsseitig einerseits mit dem Schieberegisterausgang und andererseits mit dem Ausgang des zweiten Verstärkers 12 verbunden, während er ausgangsseitig an dem Eingang des ersten Verstärkers 11 angeschlossen ist. Der Rechteckimpulsgenerator 15 ist einerseits mit dem Takt- bzw. Clock-Eingang des Schieberegisters 13 und andererseits mit den nur durch Pfeile schematisch angedeuteten Schaltern der jeden Verstärker 11,12 zugeordneten Kapazitäten verbunden.

Das durch das Prinzipschaltbild der Fig. 1 gestellte Filter zweiter Ordnung hat eine Übertragungsfunktion:

$$H(z) = -\frac{B \cdot z^2}{1 + \frac{z^2}{A}}$$

mit den Polen bei

$$z = \pm j \sqrt{A}$$

und der Resonanzfrequenz bei

$$f = (2n + 1) \frac{f_{Takt}}{4} \qquad n = 0, 1, 2 \ldots$$

Die Resonanzfrequenz ist von den Verstärkungen A und B völlig unabhängig. Zur Einstellung einer hohen Güte wird A nur wenig kleiner gewählt als +1, z.B. A = 0,95 oder A = 0,97. $f_{Takt}$ ist die Schaltfrequenz.

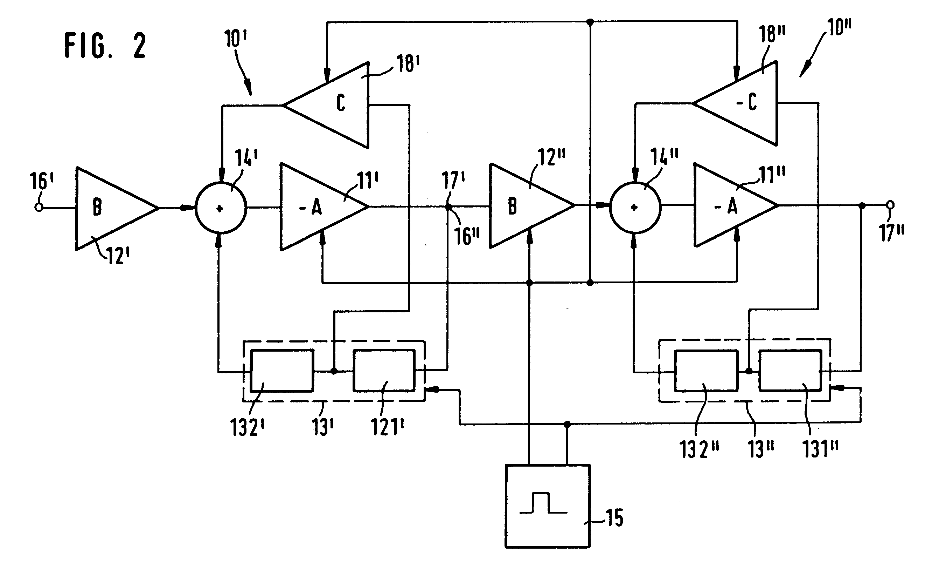

Das in Fig. 2 prinzipiell dargestellte Filter weist zwei hintereinandergeschaltete Schaltungsanordnungen 10' und 10" auf. Jede Schaltungsanordnungen 10' bzw. 10" ist weitgehend identisch mit der in Fig. 1 dargestellten Schaltungsanordnung 10, so daß gleiche Bauteile mit gleichen Bezugszeichen gekennzeichnet sind, die jedoch zur Unterscheidung mit einem oder zwei Beistriche versehen sind.

Der Unterschied der Schaltungsanordnungen 10' und 10" gegenüber der Schaltungsanordnung 10 liegt einmal darin, daß das Schieberegister 13' bzw. 13" zwei Registerstufen 131' und 132' bzw. 131" und 132" aufweist und zum anderen der Ausgang der jeweils ersten Registerstufe 131' bzw. 131" über einen dritten Verstärker 18' bzw. 18" mit dem Eingang des Summierers 14' bzw. 14" verbunden ist. Jeder der beiden dritten Verstärker 18' bzw. 18" hat eine identisch eingestellte Verstärkung C, wobei jedoch der dritte Verstärker 18" als invertierender Verstärker ausgebildet ist. Die Verstärkung C ist dabei sehr viel kleiner bemessen als die Verstärkung A der beiden ersten Verstärker 11' bzw. 11".

Jede der beiden Schaltungsanordnungen 10' bzw. 10" hat eine Übertragungsfunktion: mit den Polen bei

$$z = -\frac{C \cdot A}{2} \pm j \sqrt{A} \cdot \sqrt{1 - \frac{c^2 A}{4}} .$$

$$H(z) = -\frac{B \cdot z^2}{1 + \frac{z^2}{A} + z \cdot C} ,$$

Da $|C| \ll A$ ist, besteht die Wirkung der durch den dritten Verstärker 18' bzw. 18" erzielten Rückkopplung erster Ordnung fast ausschließlich in einer Frequenzverschiebung der Pole um

$$f = -\frac{f_{Takt}}{2\pi} \cdot \frac{C \sqrt{A}}{2} .$$

4

Die beiden hintereinandergeschalteten Schaltungsanordnungen 10' und 10'' ergeben zusammen ein Bandfilter vierter Ordnung,dessen Mittenfrequenz exakt bei $1/4 \cdot f_{Takt}$ liegt,wenn C'' = -C'' gemacht ist,und dessen Bandbreite leicht durch Wahl von|C|eingestellt werden kann, wobei die obere und untere Bandgrenze jeweils durch die Verstärkung|C| der beiden dritten Verstärker 18' und 18'' festgelegt wird. Die Bandbreite und Welligkeit des Filters ist proportional zu|C|. Durch Nachschalten eines dritten identisch ausgebildeten Filters mit der Verstärkung C = 0 läßt sich Welligkeit und Selektion noch wesentlich verbessern. Die Schaltfrequenz für die Schieberegister 13' und 13'' und für die geschalteten Kapazitäten der Verstärker 11',11'',12',12'',18' und 18'', die von einem gemeinsamen Rechteckimpulsgenerator 15 zur Verfügung gestellt wird, ist gleich dem Vierfachen der Bandmittenfrequenz, also des am Filtereingang 16' liegenden VRF-Signals, bemessen. Der Ausgang 17'' der zweiten Schaltungsanordnung 10' bildet den Filterausgang.

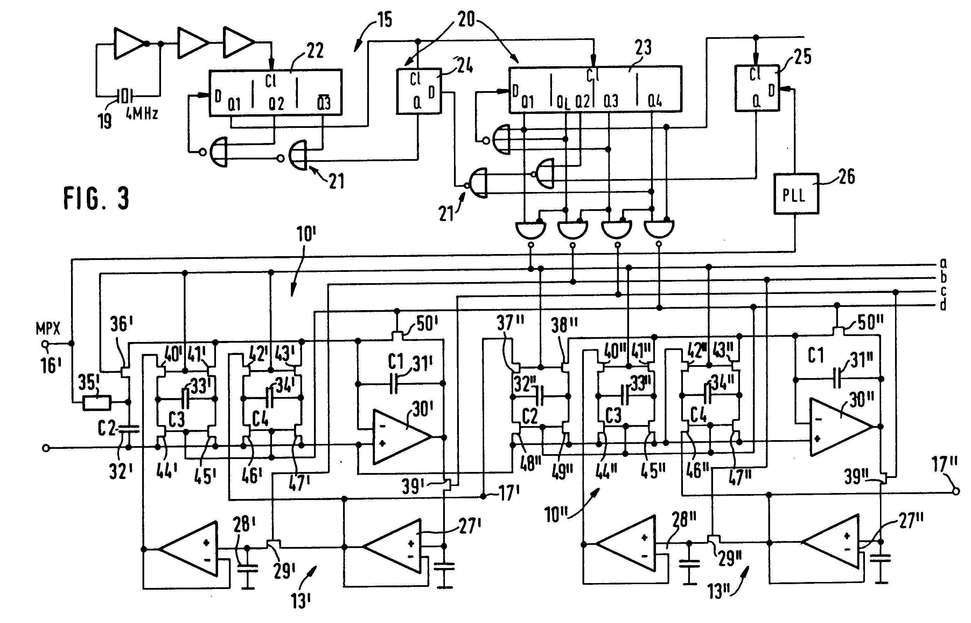

In Fig. 3 ist ein Ausführungsbeispiel einer technischen Realisierung eines Bandfilters nach dem Prinzip der Fig. 2 im einzelnen dargestellt. Der Rechteckimpulsgenerator 15 besteht aus einem 4 MHz-Quarz-Oszillator 19, einer Frequenzteilerschaltung 20 und einer Verknüpfungslogik 21. An den vier Ausgängen a,b,c und d der Verknüpfungslogik 21 sind vier Schaltimpulsfolgen mit der Impulsfolgefrequenz oder Schaltfrequenz von 228 kHz abnehmbar. Diese Schaltimpulsfolgen sind in Fig. 4 im einzelnen dargestellt. Jede Schaltimpulsfolge ist gegenüber der in aufsteigender Reihenfolge vorhergehenden Schaltimpulsfolge um 90° phasenverschoben. Da am Filtereingang 16' das MPX-Signal mit seinem 57 kHz-Träger anliegt, ist die gewählte Schaltfrequenz von 228 kHz gleich dem Vierfache der Eingangssignalfrequenz. Die in ihrer Wirkungsweise ebenso wie die Verknüpfungslogik 21 im einzelnen nicht zu erläuternde Frequenzteilerschaltung 20 weist insgesamt zwei digitale Schieberegister 22,23 und zwei D-Flip-Flops 24,25 auf. Der D-Eingang des D-Flip-Flops 25 ist mit dem Ausgang einer Phase-Locked-Loop (PLL) 26 verbunden, die zum Einrasten der Schaltfrequenz auf die Frequenz des VRF-Signals eingangsseitig mit dem Filtereingang 16' verbunden ist.

Die beiden analogen Schieberegister 13' und 13'' der beiden Schaltungsanordnungen 10' und 10'' mit ihren beiden Registerstufen sind jeweils durch zwei Sample-and Hold-Glieder 27' und 28' bzw. 27'' und 28'' gebildet, die über einen elektronischen Schalter in Form eines MOS-Feldeffekttransistors, im folgenden FET 29 genannt, miteinander zu einer Reihenschaltung verbunden sind. Die Verstärker 11',12' und 18' der Schaltungsanordnung 10' sind ebenso wie die Verstärker 11'', 12'' und 18'' der Schaltungsanordnung 10'' durch jeweils einen invertierenden Summierverstärker 30' bzw. 30'' gebildet. Jeder Summierverstärker 30' bzw. 30'' ist über einen ersten Kondensator 31' bzw. 31'' mit der Kapazität C1 gegengekoppelt. Zur Realisierung der Verstärkungen A,B und C sind in jeder Schaltungsanordnung 10' bzw. 10'' ein zweiter Kondensator 32' bzw. 32'' mit der Kapazität C2, ein dritter Kondensator 33' bzw. 33'' mit der Kapazität C3 und ein vierter Kondensator 34' bzw. 34'' mit der Kapazität C4 vorgesehen, die über elektronische Schalter in Form von MOS-FET an den Summierverstärker 30' bzw. 30'' mit Schaltfrequenz angeschlossen werden. In der Schaltungsanordnung 10' liegt hierzu der zweite Kondensator 32' über einen Widerstand 35' an dem Filtereingang, der von dem Eingang 16' der Schaltungsanordnung 10' gebildet wird, und wird über einen FET 36' an den invertierenden Eingang des Summierverstärkers 30' angeschlossen. Der dritte Kondensator 33' ist über ein FET-Paar 40',41' einerseits an den Ausgang des zweiten Sample- and Hold-Gliedes 28', im folgenden kurz SH-Glied genannt, und andererseits an den invertierenden Eingang des Summierverstärkers 30' anschließbar. Der vierte Kondensator 34' ist über ein FET-Paar 42',43' einerseits an den Ausgang des ersten SH-Gliedes 27' und andererseits an den invertierenden Eingang des Summierverstärkers 30' anschließbar. Um die Kondensatoren 31',33'und 34' nach jeder Aufsummierung und Integration im Operationsverstärker 30' auf ein definiertes Potential zu bringen, ist der Kondensator 31' mit einem FET 50' überbrückt und die Kondensatoren 33' und 34' über jeweils ein FET-Paar 44',45' bzw. 46',47' mit dem nicht invertierenden Eingang des Summierverstärkers 30' verbindbar, der mit einem Bezugspotential $U_B/2$ belegt ist. Die FET 44' - 47' der beiden FET-Paare verbinden jeweils einen Plattenanschluß des zugeordneten Kondensators 33' und 34' mit dem nicht invertierenden Eingang und werden gleichzeitig angesteuert. Bei Durchschalten der FET 50' und 44' - 47' sind die Kondensatoren 31',33' und 34' kurzgeschlossen.

In der Schaltungsanordnung 10'' ist der zweite Kondensator 32'' über ein FET-Paar 37'',38'' einerseits an den Ausgang 17' der ersten Schaltungsanordnung 10' und andererseits an den invertierenden Eingang des Summierverstärkers 30'' anschließbar. Der dritte Kondensator 33'' ist über ein weiteres FET-Paar 40'',41'' einerseits mit dem Ausgang des zweiten SH-Gliedes 28'' und andererseits mit dem invertierenden Eingang des Summierverstärkers 30'' verbindbar. Der vierte Kondensator 34'' ist über ein FET-Paar 42'',43'' aus Gründen der erforderlichen Invertierung an die beiden Eingänge des Summierverstärkers 30'' anschließbar. Die FET 37'',38'' und 40'' - 43'' der FET-Paare sind jeweils den zugeordneten Kondensator 32'' - 34'' in Reihe vor- und nachgeschaltet und werden gleichzeitig angesteuert. Der vierte Kondensator 34'' ist weiterhin über ein FET-Paar 46'',47'' einerseits mit dem Ausgang des ersten SH-Gliedes 27'' und andererseits mit dem nicht invertierenden Eingang des Summierverstärkers 30' verbindbar. Der zweite und dritte Kondensator 32'' und 33'' sind über jeweils ein FET-Paar 48'',49'' bzw. 44'',45'' mit beiden Kondensatorplatten an den nicht invertierenden Eingang des Summierverstärkers 30'' anschließbar, der wiederum mit Bezugspotential $U_B/2$ belegt ist. Der erste Kondensator 31'' ist durch einen FET 50'' überbrückbar. Der FET 50'' und die FET 44'' - 49'' werden synchron angesteuert.

In jeder Schaltungsanordnung 10' bzw. 10'' ist zwischen dem Ausgang des Summierverstärkers 30' bzw. 30'' und dem Eingang des ersten SH-Gliedes 27' bzw. 27'' ein FET 39' bzw. 39'' angeordnet. Der Ausgang des ersten SH-Gliedes 27' bildet den Ausgang 17' der Schaltungsanordnung 10', während der Ausgang des SH-Gliedes 27'' den Filterausgang 17'' bildet.

Mit der Schaltimpulsfolge a (Fig. 4) werden alle die Kapazitäten C2 - C4 an den invertierenden Eingang des Summierverstärkers 30' bzw. 30'' anschließenden FET 36',37'',38'',40',41',42',43',40'',41'',42'' und 43'' geschaltet. Entsprechend ist der Ausgang a der Verknüpfungslogik 21 mit den Gate-Elektroden der FET verbunden. Der Ausgang b der Verknüpfungslogik 21, an dem die 228 kHz-Schaltimpulsfolge um 90° phasenverschoben gegenüber dem Ausgang a ansteht, ist mit den Gate-Elektroden der FET 29' und 29'' verbunden, die jeweils zwischen den beiden Sample- and Hold-Gliedern 27' und 28' bzw. 27'' und 28'' liegen. Der Ausgang c der Verknüpfungslogik 21 ist mit den Gate-Elektroden der FET 39' und 39'' verbunden, welche jeweils den Ausgang des Summierverstärkers 30' bzw. 30'' mit dem Eingang des ersten Sample- and Hold-Gliedes 27' bzw. 27'' verbinden. Der vierte Ausgang d der Verknüpfungslogik 21 ist mit den FET 44' - 47', 44'' - 49'' und 50' und 50'' verbunden, die jeweils das Entladen der zugeordneten Kondensatoren bewirken.

Die Wirkungsweise des beschriebenen Filters ist wie folgt:
Unter Berücksichtigung des Zeitdiagramms der Rechteckimpulsfolgen an den vier Ausgängen a - d des Impulsgenerators 15 werden mit einem Impuls am Ausgang d die Kapazitäten C1 und C3 in beiden Schaltungsanordnungen 10' und 10'', die Kapazität C4 in der Schaltungsanordnung 10' und die Kapazität C2 in der Schaltungsanordnung 10'' entladen. Die Kapazität C4 in der Schaltungsanordnung 10'' wird zwecks Invertierung einerseits über den FET 46'' an den Ausgang des ersten Sample- and Hold-Gliedes 27'' und andererseits über den FET 47'' an den nicht invertierenden Eingang des Summierverstärkers 30'' gelegt.

Mit dem folgenden Impuls am Ausgang a des Impulsgenerators 15 findet in jeder Schaltungsanordnung 10' und 10'' die Summierung und die Invertierung statt. Das Ergebnis bleibt danach am Ausgang des Summierverstärkers 30' bzw. 30'' stehen.

Mit dem nachfolgenden Impuls am Ausgang b des Impulsgenerators 15 wird die jeweils im ersten Sample- and Hold-Glied 27' bzw. 27'' enthaltene Information in das zweite Sample- and Hold-Glied 28' bzw. 28'' übernommen.

Mit dem nachfolgenden Impuls am Ausgang c des Impulsgenerators 15 wird die Ausgangsinformation des Summierverstärkers 30' bzw. 30'' in das erste Sample- and Hold-Glied 27' bzw. 27'' übernommen.

Die am Filtereingang 16' angeschlossene Reihenschaltung aus Widerstand 35' und Kondensator 32' stellt einen Tiefpaß erster Ordnung dar. Der Kondensator 32' wird mit dem Impuls am Ausgang a des Impulsgenerators 15 und mit dem Durchschalten des FET 36' entladen. Der Widerstand 35' kann durch einen hochfrequent geschalteten Kondensator ersetzt werden.

Im Vergleich zu dem Prinzipschaltbild zu Fig. 2 werden die einzelnen Verstärkungen A,B und C durch folgende Kapazitätsverhältnisse gewonnen:

$$A = \frac{C_3}{C_1}$$

$$B = \frac{C_2}{C_3}$$

$$C = \frac{C_4}{C_3} \cdot$$

Die Erfindung ist nicht auf die beschriebenen Ausführungsbeispiele beschränkt. So kennen das oder die Schieberegister auch durch Eimerkettenschaltungen realisiert werden.

Auch kann die Anzahl der Registerstufen größer als zwei gewählt werden. Bei z.B. drei Registerstufen, im Falle der Fig. 3 drei Sample- and Hold-Gliedern, erhält man bei einer Schaltfrequenz` die notwendigerweise gleich dem Sechsfachen der Eingangssignalfrequenz sein muß, wiederum eine Treppenkurve mit insgesamt sechs Werten pro Signalperiode. Ein solches Filter findet dort Einsatz, wo statt der beim VRF-Signal interessanten orthogonalen Komponenten andere Phasen des Signals die Information in z.B. 600 Phasensprüngen enthalten.

## Patentansprüche

1. Aktives Filter mit geschalteten Kapazitäten für das VRF-Signal eines UKW-Empfängers, umfassend eine Schaltungsanordnung (10;10';10'') aus einem invertierenden Verstärker (11;11';11''), einem analogen Schieberegister (13;13';13'') mit mindestens zwei Register- bzw. Verzögerungsstufen (131; 131';131'') und einem Summierer (14;14';14''), der eingangsseitig mit dem Eingang der Schaltungsanordnung (10;10';10''), vorzugsweise über einen weiteren Verstarker(12;12'12''),und mit dem Ausgang des Schieberegisters (13;13';13'') und ausgangsseitig mit dem Eingang des invertierenden Verstärkers (11;11';11'') verbunden ist, dadurch gekennzeichnet, daß die Schaltfrequenz der Kapazitäten und des Schieberegisters (13;13'; 13'') gleich dem mit der Anzahl der Registerstufen (131';132';131'',132'') des Schieberegisters (13;13'; 13'') multiplizierten Zweifachen der gewünschten Bandmittenfrequenz bemessen ist.

2. Filter nach Anspruch 1, **dadurch gekennzeichnet**, daß die Verstärkung (A) des invertierenden Verstärkers (11;11';11'') nur wenig kleiner als 1, z.B. 0,97 oder 0,95, gewählt ist.

3. Filter nach Anspruch 1 oder 2, **dadurch gekennzeichnet**, daß der Ausgang der im Schieberegister (13';13'') ersten Registerstufe (131';131'') über einen dritten Verstärker (18';18'') an einem weiteren Eingang des Summierers (14';14'') angeschlossen ist und daß die Verstärkung (C) des dritten Verstärkers (18';18'') sehr viel kleiner bemessen ist als die Verstärkung(A) des invertierenden Verstärkers (11';11'').

4. Filter nach Anspruch 3, **dadurch gekennzeichnet**, daß am Ausgang der Schaltungsanordnung (10') eine zweite Schaltungsanordnung (10'') angeschlossen ist, die identisch der ersten Schaltungsanordnung (10') ist mit dem Unterschied, daß der dritte Verstärker als invertierenderVerstärker (18'') ausgebildet ist, und daß der Filtereingang von dem Eingang (16') der ersten Schaltungsanordnung (10') und der Filterausgang von dem Ausgang (17'') der zweiten Schaltungsanordnung (10'') gebildet ist.

5. Filter nach einem der Ansprüche 1 - 4, **dadurch gekennzeichnet**, daß das Schieberegister (13';13'') von einer Anzahl von hintereinandergeschalteten Sample- and Hold-Gliedern (27',28';27'',28'') gebildet ist.

6. Filter nach einem der Ansprüche 1 - 5, **dadurch gekennzeichnet**, daß die Verstärker (11',12',18') und der Summierer (14') von einem über einen ersten Kondensator (31') gegengekoppelten Operationsverstärker (30') gebildet sind, an dessen invertierendem Eingang über jeweils mindestens einen mit Schaltfrequenz geschalteten ersten elektronischen Schalter (36',40' - 43')ein dem Filtereingang (16') zusammen mit einem Widerstand (35') parallel geschalteter zweiter Kondensator (32'), ein in Reihe mit dem Ausgang des Schieberegisters (13') liegender dritter Kondensator (33') und ein in Reihe mit dem Ausgang der ersten Registerstufe (27') des Schieberegisters (13') liegender vierter Kondensator (34') angeschlossen ist.

7. Filter nach Anspruch 4 und 6, **dadurch gekennzeichnet**, daß die Verstärker (11'',12'',18'') und der Summierer (14'') der zweiten Schaltungsanordnung (10'') von einem über einen ersten Kondensator (31'') gegengekoppelten Operationsverstärker (30'') gebildet sind, an dessen invertierendem Eingang über jeweils mindestens einen mit Schaltfrequenz geschalteten ersten elektronischen Schalter (37'';38'',40'' - 43'') ein an dem Ausgang der ersten Schaltungsanordnung (10') angeschlossener zweiter Kondensator (32'), ein in Reihe mit dem Ausgang des Schieberegisters (13'') liegender dritter Kondensator (33'') und ein mit dem nicht invertierenden Eingang des Operationsverstärkers (30'') verbindbarer vierter Kondensator (34') angeschlossen ist und daß der vierte Kondensator (34'') über mindestens einen vierten elektronischen Schalter (46'',47'') einerseits an den Ausgang der ersten Registerstufe (27'') des Schieberegisters (13'') und andererseits an den nicht invertierenden Eingang des Operationsverstärkers (30'') anschließbar ist.

8. Filter nach einem der Ansprüche 6 oder 7, **dadurch gekennzeichnet**, daß das Schieberegister (13';13'') aus zwei über einen mit Schaltfrequenz getakteten zweiten elektronischen Schalter (29';29'') hintereinandergeschalteten Sample- and Hold-Gliedern (27',28';27'',28'') besteht, von denen das erste Sample- and Hold-Glied (27'; 27'') eingangsseitig über einen mit Schaltfrequenz getakteten dritten elektronischen Schalter (39'; 39'') mit dem Ausgang des Operationsverstärkers (30':30'') verbunden ist, und daß der Ausgang des zweiten Sample- and Hold-Gliedes (28';28'') den Ausgang des Schieberegisters (13';13'') und der Ausgang des ersten Sample- and Hold-Gliedes (27'; 27'') den Ausgang der ersten Registerstufe (131'; 131'') des Schieberegisters (30';30'') bildet.

9. Filter nach einem der Ansprüche 1 -8 , **dadurch gekennzeichnet**, daß eine Phase-Locked-Loop (PLL 26) vorgesehen ist, die so eingestellt ist, daß die Schaltfrequenz auf dem Vierfachen der Frequenz des VRF-Signals einrastet.

**Claims**

1. Active filter with switched capacitors for the TP signal of a VHF receiver, comprising a circuit arrangement (10; 10'; 10'') consisting of an inverting amplifier (11; 11'; 11''), an analogue shift register (13; 13'; 13'') with at least two register or delay stages (131; 131'; 131'') and a summer (14; 14'; 14''), which is connected on the input side to the input of the circuit arrangement (10; 10'; 10''), preferably via a further amplifier (12; 12'; 12''), and to the output of the shift register (13; 13'; 13''), and on the output side to the input of the inverting amplifier (11; 11'; 11''), characterised in that the switching rate of the capacitors and the shift register (13; 13'; 13'') is dimensioned to be equal to two times the desired midband frequency multiplied by the number of the register stages (131'; 132'; 131'', 132'') of the shift register (13; 13'; 13'').

2. Filter according to Claim 1, characterised in that the gain (A) of the inverting amplifier (11; 11'; 11'') is selected to be only slightly slightly smaller than one, for example 0.97 or 0.95.

3. Filter according to Claim 1 or 2, characterised in that the output of the first register stage (131'; 131'') in the shift register (13'; 13'') is connected via a third amplifier (18'; 18'') to a further input of the summer (14'; 14''), and in that the gain (C) of the third amplifier (18'; 18'') is dimensioned to be very much smaller than the gain (A) of the inverting amplifier (11'; 11'').

4. Filter according to Claim 3, characterised in that connected at the output of the circuit arrangement (10') is a second circuit arrangement (10'') which is identical to the first circuit arrangement (10') with the difference that the third amplifier is constructed as an inverting amplifier (18''), and in that the filter input is formed by the input (16') of the first cicuit arrangement (10') and the filter output is formed by the output (17'') of the second circuit arrangement (10'').

5. Filter according to one of Claims 1-4, characterised in that the shift register (13'; 13'') is formed by a number of series-connected sample-and-hold elements (27', 28'; 27'', 28'').

6. Filter according to one of Claims 1-5, characterised in that the amplifer (11', 12', 18') and the summer (14') are formed by an operational amplifier (30') which is degeneratively fed back via a first capacitor (31') and to the inverting input of which there are connected via in each case at least one first electronic switch (36', 40'-43') switched at the switching rate a second capacitor (32'), which is connected in parallel to the filter input (16') together with a resistor (35'), a third capacitor (33'), located in series with the output of the shift register (13'), and a fourth capacitor (34') located in series with the output of the first register stage (27') of the shift register (13').

7. Filter according to Claims 4 and 6, characterised in that the amplifier (11'', 12'', 18'') and the summer (14'') of the second circuit arrangement (10'') are formed by an operational amplifier (30'') which is degeneratively fed back via a first capacitor (31'') and to the inverting input of which there are connected via in each case at least one first electronic switch (37''; 38'', 40''-43'') switched at the

8

switching rate a second capacitor (32'), connected to the output of the first circuit arrangement (10'), a third capacitor (33''), located in series with the output of the shift register (13''), and a fourth capacitor (34'), which can be connected to the non-inverting input of the operational amplifier (30''), and in that the fourth capacitor (34'') can be connected via at least one fourth electronic switch (46'', 47'') to the output of the first register stage (27'') of the shift register (13''), on the one hand, and to the non-inverting input of the operational amplifier (30''), on the other hand.

8. Filter according to one of Claims 6 or 7, characterised in that the shift register (13'; 13'') consists of two sample-and-hold elements (27', 28'; 27'', 28''), which are connected in series via a second electronic switch (29, 29'') clocked at the switching rate, and of which the first sample-and-hold element (27'; 27'') is connected on the input side via a third electronic switch (39'; 39'') clocked at the switching rate to the output of the operational amplifier (30'; 30''), and in that the output of the second sample-and-hold element (28'; 28'') forms the output of the shift register (13'; 13''), and the output of the first sample-and-hold element (27'; 27'') forms the output of the first register stage (131'; 131'') of the shift register (30'; 30'').

9. Filter according to one of Claims 1-8, characterised in that a phase-locked loop (PLL 26) is provided, which is set so that the switching rate is locked at four times the frequency of the TP signal.

## Revendications

1. Filtre actif à capacités commutées pour le signal VRF d'un récepteur MF, comprenant un montage (10, 10', 10'') formé d'un amplificateur inversé (11, 11', 11''), d'un registre à décalage analogique (13, 13', 13'') avec au moins deux étages de registre ou de temporisation (131, 131', 131'') et un additionneur (14, 14', 14'') dont l'entrée est reliée à l'entrée du montage (10, 10', 10''), de préférence par l'intermédiaire d'un autre amplificateur (12, 12', 12'') et à la sortie du registre à décalage (13, 13', 13''), la sortie de cet additionneur étant reliée à l'entrée de l'amplificateur inverseur (11, 11', 11''), caractérisé en ce que la fréquence de commutation des capacités du registre à décalage (13, 13', 13'') est égale au nombre d'étages de registre (131', 132', 131'', 132'') du registre à décalage (13, 13', 13'') multiplié par le double de la fréquence centrale de bande souhaitée.

2. Filtre selon la revendication 1, caractérisé en ce que le coefficient d'amplification (A) de l'amplificateur inversé (11, 11', 11'') n'est que légèrement inférieur à 1, par exemple 0,97 ou 0,95.

3. Filtre selon la revendication 1 ou 2, caractérisé en ce que la sortie du premier étage (131', 131'') du registre à décalage (13', 13'') est reliée par un troisième amplificateur (18', 18'') à une autre entrée de l'additionneur (14', 14'') et en ce que le coefficient d'amplification (C) du troisième amplificateur (18', 18'') est beaucoup plus petit que le coefficient d'amplification (A) de l'amplificateur inversé (11', 11'').

4. Filtre selon la revendication 3, caractérisé en ce que la sortie du circuit (10') est reliée à un second circuit (10'') identique au premier circuit (10') sauf que le troisième amplificateur est un amplificateur inverseur (18'') et l'entrée du filtre est constituée par l'entrée (16') du premier circuit (10') et la sortie du filtre est constituée par la sortie (17'') du second circuit (10'').

5. Filtre selon l'une des revendications 1 à 4, caractérisé en ce que le registre à décalage (13', 13'') est formé par un certain nombre d'éléments d'échantillonnage et de maintien (27', 28', 27'', 28'') branchés les uns à la suite des autres.

6. Filtre selon l'une des revendications 1 à 5, caractérisé en ce que l'amplificateur (11', 12', 18') et l'additionneur (14') sont formés par un amplificateur opérationnel (30') couplé en contre-réaction par l'intermédiaire d'un premier condensateur (31') et l'entrée inversée de cet amplificateur est reliée par au moins un premier commutateur électronique (36', 40' - 43') commuté à la fréquence de commutation avec l'entrée de filtre (16') ainsi qu'avec une résistance (35') en parallèle avec un second condensateur (32'), un troisième condensateur (33') en série avec la sortie du registre à décalage (13') et un quatrième condensateur (34') en série avec la sortie du premier étage de registre (27') du registre à décalage (13').

**7.** Filtre selon les revendications 4 et 6, caractérisé en ce que le quatrième amplificateur (11'', 12'', 18'') et l'additionneur (14'') du second circuit (10'') sont formés par un amplificateur opérationnel (30'') couplé en contre-réaction par un premier condensateur (31''), amplificateur dont l'entrée inversée est reliée par au moins un premier commutateur électronique (37'', 38'', 40'' - 43'') commuté à la fréquence de commutation à un second condensateur (32') relié à la sortie du premier circuit de commutation (10'), un troisième condensateur (33'') étant en série avec la sortie du registre à décalage (13'') et un quatrième condensateur (34') étant relié à l'entrée non inversée de l'amplificateur opérationnel (30''), et en ce que le quatrième condensateur (34'') est relié par au moins un quatrième commutateur électronique (46'', 47''), d'une part, à la sortie du premier étage à registre (27'') du registre à décalage (13'') et, d'autre part, à l'entrée non inversée de l'amplificateur opérationnel (30'').

**8.** Filtre selon l'une des revendications 6 ou 7, caractérisé en ce que le registre à décalage (13' ; 13'') se compose de deux éléments d'échantillonnage et de maintien (27', 28' ; 27'', 28'') commutés par un second commutateur électronique (29' ; 29'') commandé en cadence à la fréquence de commutation, le premier de ces éléments (27' ; 27'') étant relié en entrée à un troisième commutateur électronique (39' ; 39'') commandé à la cadence de la fréquence de commutation en étant relié à la sortie de l'amplificateur opérationnel (30' ; 30'') et en ce que la sortie du second élément d'échantillonnage et de maintien (28' ; 28'') forme la sortie du registre à décalage (13' ; 13'') et la sortie du premier élément d'échantillonnage et de maintien (27' ; 27'') forme la sortie du premier étage (131' ; 131'') du registre à décalage (30' ; 30'').

**9.** Filtre selon l'une des revendications 1-8, caractérisé par une boucle à verrouillage de phase (boucle PLL 26) réglée pour que la fréquence de commutation s'accroche sur le quadruple de la fréquence du signal VRF.

FIG. 1

FIG. 4

FIG. 2

EP 0 260 545 B1

FIG. 3